# EUROPEAN PATENT APPLICATION

(11) **EP 4 703 957 A1**
(43) Date of publication of application: **04.03.2026**
(21) Application number: 24465565.0
(22) Date of filing: 28.08.2024
(51) Int. Cl.: G06F 30/27, G06F 30/33, G06F 30/3308

(54) **METHOD FOR VERIFICATION OF A TARGET DESIGN, METHOD FOR TRAINING CORNER CASE INVESTIGATION MODULE, VERIFICATION DEVICE, TEST DEVICE, COMPUTER PROGRAM PRODUCT AND COMPUTER-READABLE STORAGE MEDIUM**

(71) Applicant: Siemens Aktiengesellschaft, 80333 München (DE)
(72) Inventor: GHEORGHE, Stefan, 100456 Ploiesti, Prahova (RO); PUIU, Elena Carmina, 507055 Cristian, Brasov (RO); BANCIU, Nicolae-Alexandru, 500096 Brasov (RO)
(74) Representative: Fierascu, Cosmina-Catrinel

(57) **Abstract**

The invention relates to a method for verification of a target design (12), the method comprising the following steps performed by a verification device (32). Receiving a corner case scenario (28) of the target design (12), the corner case scenario (28) comprising a corner case state of the target design (12) satisfying corner case conditions causing a corner case in the target design (12); Investigating by a sequence investigation module (30) of the verification device (32), a set of sequences (34) comprising one or more sequences of steps (36), for transferring the target design (12) from a start state of the target design (12) to the corner case state of the target design (12); and generating control data (40) for a test device (42) to control the target design (12) to perform the operation steps of at least one sequence of steps (36) of the set of sequences (34).

## Description

The present invention relates to a method for verification of a target design, a method for training corner case investigation module, a verification device, a test device, a computer program product and a computer-readable storage medium.

Hardware design verification is a detailed process that involves a comprehensive understanding of the system architecture, architectural diagrams and create scenarios with potential failure modes named corner cases.

A corner case refers to a behavior, whether expected or unexpected, that has the potential to affect the stability or performance of hardware systems. These cases are often unanticipated and may not be captured by typical test scenarios. Given the significant time and resources required to identify these special scenarios, as well as the risk of overlooking them entirely, which could result in financial impact and other types of hazards due to malfunctioning, it is crucial to be aware of potential corner cases from the outset of the verification process.

Analyzing and addressing potential vulnerabilities by considering corner cases is essential for ensuring the reliability and robustness of hardware systems. In recent times, there has been a trend towards combining AI techniques such as machine learning and deep learning with traditional verification methodologies to enhance overall verification accuracy. Hybrid approaches that incorporate AI techniques can optimize verification efforts by focusing on critical areas or corner cases that may arise during different phases of the design process.

However, there are potential drawbacks to this approach. Verification engineers need to understand the underlying mechanisms behind training AI algorithms and acquire comprehensive and representative datasets for training and validation from various sources, including physical measurements, simulation results, and historical data. Moreover, predictions derived from Al-based models must be both comprehensive and interpretable, thereby maximizing their usability in practice.

The traditional verification methods include Simulation-Based Verification such as directed testing, constrained-random testing, coverage driven testing, and formal verification techniques. This approach primarily relies on human effort. A verification engineer must identify potential corner cases for a specific project and implement test cases to reach those states, which requires significant time and effort.

The fusion of hardware design verification and AI is a dynamic and expanding domain where AI-driven solutions demonstrate considerable efficacy in identifying and addressing intricate corner cases, improving verification processes. Hardware design verification utilizing AI is a promising field, with Al-powered solutions excelling in identifying complex interactions, learning from diverse data sources, and adapting to new scenarios, making them increasingly favored in the verification process.

Currently, there is extensive ongoing research dedicated to leveraging AI methodologies such as RL agents, deep learning-based fault localization, GANs, Bayesian Networks, transfer learning, and ensemble methods to address the challenge of identifying corner cases in hardware design verification. However, despite theoretical advancements, practical implementation of these techniques remains largely unexplored. Consequently, verification engineers are predominantly constrained to traditional verification methods, which, while effective, tend to be laborious and time-consuming.

It is an object of the present invention to provide a solution for finding corner cases for a target design. Another object of the present invention is to provide a method to provide test cases for reaching a corner case state of the target design.

This objective is achieved by the respective subject matter of the independent claims. Further implementations and preferred embodiments are subject matter of the dependent claims.

The present invention is related to a method for verification of a target design. The method comprises the following steps performed by a verification device.

A novelty of the proposed approach derives from a usage of Generative AI to identify corner case scenarios for a target design and the usage of RL agents to fulfill the corner case scenarios, reducing a load on the hardware verification team for both scenario definition, starting from a list of possible candidate scenarios, and the actual scenario implementation that can be fully automated, needing only computational resources instead of human resources.

A first step comprises receiving, by the verification device, a corner case scenario of the target design. The corner case scenario is related to a behaviour of the target design that might impact a stability of the target design or the performance of the target design. The corner case scenario is related to a specific corner case occurring in the target design. The corner case scenario may comprise a corner case state of the target design satisfying a corner case condition that causes the corner case. In other words, the corner case scenario is related to a specific event that influences a proper behavior of the target design. A situation, comprising the state of the target design, when the corner case happened is described in the corner case scenario. For a further analysis of the corner case, the target design and the corner case scenario describing the corner case are provided to the verification device in the first step. The corner case scenario may be generated in a simulation, predicted by a model device or may have occurred in an operation of a physical device of the target design.

To understand the corner case, it may be necessary to determine steps of operation that set the target design to the corner case state, in which the corner case occurred. Therefore, a next step comprises an investigation performed by a sequence investigation module of the verification device of a sequence set comprising one or more sequences of steps. Each of the sequences of the steps comprise operation steps of the target design for transferring the target design from a start state of the target design to the corner case state of the target design.

In other words, the corner case state, describing the state of the target design that causes the corner case, is known. To allow an analysis of the corner case, it is necessary to provide steps of operation to set the target design into the corner case state. Therefore, the sequence investigation module is provided and is configured to investigate one or more sequences of steps that must be performed on the target design to set it in the corner case state. A start state of the target design may be a state of the target design after switching it on or a predefined state of operation. There may be more than one sequence of steps to transfer the target design from the start state to the corner case state. The sequence investigation module may investigate the sequence set comprising the one or more sequences of steps. At the end of the investigation, the sequence of steps for reaching the corner case state is provided.

To analyze the corner case, control data for operating an entity of the target design according to the sequence of steps must be determined to perform a respective test on an entity of the target design. Therefore, a next step comprises generating control data for a test device to control the entity of the target design to perform the operations of at least one sequence of steps in the sequence set, in order to transfer the entity of the target design to the corner case state of the target design. In other words, to examine the corner case, the entity of the target device must perform the corresponding operation steps. To allow a test procedure to be performed on the entity of the target device by a test device, the verification device generates control data for the test device. The control data instruct the test device to control the entity of the target design to perform the operations of at least one sequence of steps in the sequence set, in order to transfer the entity of the target design to the corner case state of the target design.

The invention has the advantage that the verification device provides control data to set the entity of the target design into the corner case state, causing the corner case. Therefore, the occurrence of the corner case can be studied using the test device.

According to a further embodiment of the present invention, the sequence investigation module comprises a set of reinforcement learning agents configured to investigate the sequence set according to a multiple-agent reinforcement learning procedure. The multi-agent reinforcement learning procedure is a machine learning approach where the multiple intelligent agents act to achieve specific goals. In this context, several reinforcement learning agents collaborate to investigate the sequence set to transfer the target design into the corner case state. Each agent proposes different sequences of steps, enabling the set of agents to collectively discover the sequence set. Therefore different sequences of steps may be provided in the method.

According to a further embodiment of the present invention, the method comprises a step of providing the control data to the test device by the verification device. The test device is configured as a device that is configured to perform a predefined test procedure on the entity of the target design. The test device may be a module of the verification device or an independent device. The test device may be configured to operate a virtual test environment to perform the test procedure on a digital representation of the target design in the verification environment. The test device may also be configured to control a physical entity of the target design. The method comprises a step of controlling the entity of the target design by the test device using control data to transfer the entity of the target design to the corner case state in the predefined test procedure. In other words, the test device controls the entity of the target design to perform the steps of the sequence. A next step comprises recording test data during the test procedure by the test device. A subsequent step comprises providing test data recorded during the test procedure to the verification device. The embodiment has the advantage that the corner case can be simulated on an entity of the test device.

According to a further embodiment of the present invention, the entity of the target design is configured as a digital representation of the target design provided in a test environment operated by the test device. In other words, the test procedure is performed on a digital representation of the target design in the test environment provided by the test device. The test device is configured to perform the predefined test procedure on the digital representation of the target design in the test environment. The entity of the target design is represented as the digital representation operating in the test environment. The test device is configured to provide input data according to the control data to the digital representation of the target design operating in the test environment. The test device is configured to receive the test data, which describes the digital representation of the target design, including output provided by the target design in the test environment. The embodiment has the advantage that the corner case is analyzed on a virtual representation of the target design. This allows an analysis of the corner case without a need to use a physical entity of the target design.

According to a further embodiment of the present invention, the entity of the target design is configured as a physical entity of the target design connected to the test device. In other words, the test procedure is performed on a physical device of the target design, connected to the test device. The test device is configured to provide input data to the physical entity according to the control data, thereby performing the predefined test procedure on the physical entity of the target design. The embodiment has the advantage, that the corner case can be analyzed on a physical entity of the target design.

According to a further embodiment of the present invention, the method comprises the step of receiving the target design and its respective target design specifications by the verification device. The target design may be a digital representation of the target system provided in a hardware description language. The target design specifications may be specifications of the target design. A next step comprises identifying by the corner case investigation module of the verification device candidate corner case scenarios of the target design during a corner case identification procedure. In other words, the verification device uses an investigation module to identify candidate corner case scenarios of the target design. The verification device provides the target design and its respective target design specifications to the corner case investigation module. The corner case investigation module is configured to investigate the candidate corner case scenarios of the target design being possible corner case scenarios that are identified by the corner case investigation module. The corner case investigation module may comprise a model trained on provided designs and provided corner cases of the respective provided designs. Therefore, the corner case investigation module may investigate candidate corner case scenarios in the provided target design. The method comprises the step of selecting the corner case scenario from the candidate corner case scenarios investigated by the corner case investigation module according to a predefined selection criterion. In other words, one of the candidate corner case scenarios is selected as the corner case scenario to be used in the method.

According to a further embodiment of the present invention, the method comprises a step of providing the candidate corner case scenarios of the target design to an evaluation module of the verification device. A next step comprises evaluating respective evaluation values for the respective candidate corner case scenarios by the evaluation module. The corner case scenario is selected from the candidate corner case scenarios as a function of the evaluation values. In other words, the corner case investigation module may investigate one or more of the candidate corner case scenarios for the target design. However not every candidate corner case scenario investigated for the target design may be a real corner case scenario. It may also be possible, that a respective one of the candidate corner case scenarios is a real corner case scenario but that the respective candidate corner case scenario is only an insignificant corner case. To allow an identification of suitable corner case scenarios of the candidate corner case scenarios, the candidate corner case scenarios are provided to the evaluation device by the corner case investigation module. The evaluation device is configured to provide a respective evaluation value for each of the candidate corner case scenarios. The evaluation value may be generated using a model, trained to evaluate candidate corner case scenarios. The evaluation value may also be evaluated in a short simulation algorithm, simulating the respective candidate corner case scenario to verify a presence of a corner case. The evaluation value may also be used to distinguish hallucinations and false predictions from real corner cases. The corner case scenario may be selected from the candidate corner case scenarios according to a predefined criterion. It may be possible that the predefined criterion relates to the evaluation values evaluated for the candidate corner case scenarios. The predefined criterion may require a selection of the candidate corner case scenario of a predefined or best evaluation value.

According to a further embodiment of the present invention, the corner case investigation module comprises a generative AI tasked with identifying corner case scenarios in the target design. In other words, the corner case investigation module comprises the generative AI. The generative AI is trained to identify corner case scenarios in the target design. In other words, the corner case investigation module is configured to operate a generative AI that is responsible for identifying corner case scenarios within the target design. In other words, the corner case investigation module utilizes Generative AI to identify corner case scenarios for the target design. A purpose of the corner case investigation module is to detect potential issues in the target design by analyzing and generating various candidate corner case scenarios based on a standardized example database compiled by verification engineers from their experience. The AI system identifies project-specific corner cases, which are then reviewed and refined by a verification team before being fed back into the Generative AI to enhance the standardized example database for future iterations of the process.

According to a further embodiment of the present invention, the corner case investigation module uses a Large Language Model enhanced with Retrieval-Augmented Generation. In other words, the case investigation module utilizes a Large Language Model (LLM) integrated with Retrieval-Augmented Generation (RAG) to investigate the candidate corner case scenarios in the target design. This approach enables the corner case investigation module to generate highly accurate and relevant candidate corner case scenarios when investigating potential issues within the target design. By utilizing RAG, the LLM is able to retrieve contextual information from a large dataset or database, allowing it to provide more informed responses related to specific corner case scenarios for the target design in question. This combination of LLM and RAG technologies significantly enhances the reliability and accuracy of the case investigation module's corner case scenarios, providing valuable insights that help ensure the target design is robust and free from potential issues or vulnerabilities.

A second aspect of the present invention is related to a method for training the corner case investigation module.

The method comprises the following steps performed by a verification device.

A first step comprises receiving a target design and a respective target design specification.

A next step comprises identifying by the corner case investigation module of the verification device candidate corner case scenarios of the target design in a predefined corner case identification procedure. A next step comprises evaluating respective evaluation values for the respective candidate corner case scenarios by the evaluation module. A next step comprises selecting corner case scenarios from the candidate corner case scenarios as a function of the evaluation values. A next step comprises providing the corner case scenarios to the corner case investigation module for training and/or updating the corner case investigation module.

For use cases or use situations which may arise in the methods and which are not explicitly described here, it may be provided that, in accordance with the methods, an error message and/or a prompt for user feedback is output and/or a default setting and/or a predetermined initial state is set.

A third aspect of the present invention is related to a verification device. The verification device is configured to perform a method for verification of a target design according to the first aspect of the present invention and/or the verification device is configured to perform a method for training a corner case investigation module according to the second aspect of the present invention.

A fourth aspect of the present invention is related to a test device. The test device is configured to receive control data from a verification device and to control an entity of a target design according to the control data to transfer the entity of the target design to a corner case state in a predefined test procedure. The test device is configured to record test case results during the test procedure and to provide the test case results recorded during the test procedure to the verification device.

A fifth aspect of the present invention is related to a computer program product comprising program code for performing a method according to the first aspect of the present invention and/or according to a second aspect of the present invention. The computer program product may also be regarded as a computer program.

A sixth aspect of the invention is related to a computer-readable storage medium comprising at least the computer program product according to the fifth aspect.

The hardware verification device and the test device may comprise computing devices to perform steps of the methods.

A computing device may in particular be understood as a data processing device, which comprises processing circuitry. The computing device may therefore in particular process data to perform computing operations. This may also include operations to perform indexed accesses to a data structure, for example a look-up table, LUT.

In particular, the computing device may include one or more computers, one or more microcontrollers, and/or one or more integrated circuits, for example, one or more application-specific integrated circuits, ASIC, one or more field-programmable gate arrays, FPGA, and/or one or more systems on a chip, SoC. The computing device may also include one or more processors, for example one or more microprocessors, one or more central processing devices, CPU, one or more graphics processing devices, GPU, and/or one or more signal processors, in particular one or more digital signal processors, DSP. The computing device may also include a physical or a virtual cluster of computers or other of said devices.

In various embodiments, the computing device includes one or more hardware and/or software interfaces and/or one or more memory devices.

A memory device may be implemented as a volatile data memory, for example a dynamic random access memory, DRAM, or a static random access memory, SRAM, or as a non-volatile data memory, for example a read-only memory, ROM, a programmable read-only memory, PROM, an erasable read-only memory, EPROM, an electrically erasable read-only memory, EEPROM, a flash memory or flash EEPROM, a ferroelectric random access memory, FRAM, a magnetoresistive random access memory, MRAM, or a phase-change random access memory, PCRAM.

### Independent of the grammatical term usage, individuals with male, female or other gender identities are included within the term.

Further features of the invention are apparent from the claims, the figures and the figure description. The features and combinations of features mentioned above in the description as well as the features and combinations of features mentioned below in the description of figures and/or shown in the figures may be comprised by the invention not only in the respective combination stated, but also in other combinations. In particular, embodiments and combinations of features, which do not have all the features of an originally formulated claim, are also comprised by the invention. Moreover, embodiments and combinations of features which go beyond or deviate from the combinations of features set forth in the recitations of the claims are comprised by the invention.

In the following, the invention will be explained in detail with reference to specific exemplary implementations and respective schematic drawings. In the drawings, identical or functionally identical elements may be denoted by the same reference signs. The description of identical or functionally identical elements is not necessarily repeated with respect to different figures.

In the figures,
FIG 1 shows a schematic illustration of a method for training a corner case investigation module of the verification device;
FIG 2 shows a schematic illustration of the steps for providing a corner case scenario for a target design by the corner case investigation module; and
FIG 3 shows a schematic illustration of the steps of the method for investigating a sequence set.

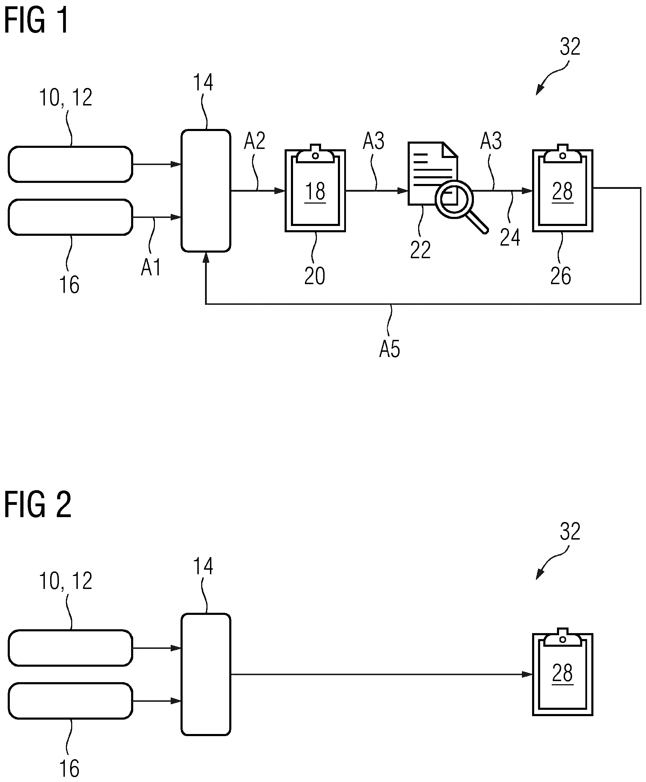

FIG 1 shows a schematic illustration of a method for training a corner case investigation module of the verification device

In a first step A1, a design specification 10, which may comprise the target design 12 and its specifications, may be submitted to the corner case investigation module 14. Additionally, examples of past corner cases 16, comprising example corner case scenarios 28 from previous target designs 12 where the respective corner cases occurred, may be provided to the corner case investigation module 14. A corner case scenario 28 may represent a state of the target design 12 that meets certain conditions leading to the manifestation of the corner case in the respective target design 12.

In the following step A2, the corner case investigation module 14 may utilize this information to generate candidate corner case scenarios 28 applicable to the target design 12. These candidate corner cases may comprise potential corner case states of the target design 12 that might meet the conditions of the respective corner case scenario 28.

Subsequently, these candidate corner case scenarios 28 may be provided to an evaluation module 22 in a step A3. The evaluation module 22 may be configured for evaluating each candidate corner case scenario 28 by providing corresponding evaluation values 24. The evaluation may also involve modifying or altering the candidate corner case scenarios 28 as needed. The evaluation module 22 may also delete any false alerts or invalid candidate corner case scenarios 28 during this process.

An approved corner case scenarios list 26 may be generated A4. The approved corner case scenario list 26 may comprise those candidate corner case scenarios 28 that may meet predefined criteria based on their evaluation values 24. The approved corner case scenario list 26 may serve as a repository of validated corner cases for future reference and analysis. The approved corner case scenario list 26 may be provided to the corner case investigation module 14 to train the corner case investigation module 14 A5.

The method may comprise a use of a corner case description example database that may be compiled by hardware verification engineers from their experience. The respective corner case descriptions may be provided in a standardized manner and may be based on predefined templates. The target design specifications 10 together with the corner case example database may be fed into a Generative AI solution (e.g. a Large Language Model - LLM, enhanced with a Retrieval Augmented Generation - RAG ) tasked with the identification of project-specific corner cases.

The identified candidate corner case scenarios 28 may be compiled into an approved corner case scenario list 26 that may be evaluated by the evaluation module 22. The evaluation module 22 may decide the validity of the candidate corner case scenarios 28 created by the Generative AI for the target design 12 and further refine the generated list by eliminating, adding or changing candidate corner case scenarios 28. The refined approved corner case scenario list 26 may be fed back to the Generative AI in order to improve its performance for future project target design 12 investigations. The goal may be a minimization of human interaction when defining the approved corner case scenario list 26.

FIG 2 shows a schematic illustration of the steps for providing a corner case scenario for a target design by the corner case investigation module.

The corner case investigation module 14 may be trained on corner case examples, using the method described in FIG 1. The target design 12 may be provided to the corner case investigation module 14, and the corner case investigation module 14 may provide one or more corner case scenarios 28 of the target design 12.

A result may be approved corner case scenario list 26, accepted by the evaluation module 22. The candidate corner case scenarios 28 may comprise a corner case scenario 28 of the target design 12 that may be analyzed in further steps.

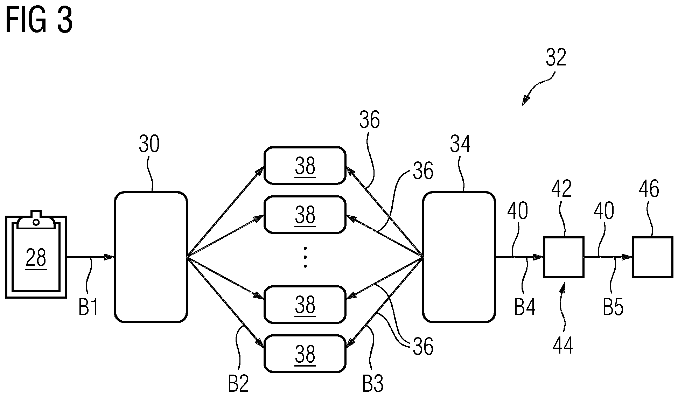

FIG 3 shows a schematic illustration of the steps of the method for investigating a sequence set.

In a first step B1, a corner case scenario 28 from those evaluated by the corner case investigation module 14 may be provided to a sequence investigation module 30 of the verification device 32. The sequence investigation module 30 of the verification device 32 may be configured to determine a set of sequences 34 to set the target design 12 into the corner case state of the corner case scenario 28. The corner case investigation module 14 may be configured to provide the corner case state of the target design 12 to respective agents 38 in a step B2.

These agents 38 may be configured to perform a multiple-agent reinforced modeling procedure, to identify different sequences of steps 36 to set the target design 12 in the corner case state. The aim of these steps is to evaluate the sequence set that comprises one or more sequences of consecutive operation steps of the target design 12 for transferring it from its start state to the corner case state.

The agents 38 may provide their respective sequences of steps 36 in a step B3, which may be collected in a set of sequences 34. This set of sequences 34 may then be provided to the verification device 32.

The verification device 32 may generate control data 40 for a test device 42 to control an entity 46 of the target design 12 to perform the operation steps of at least one sequence of steps 36 from the set of sequences 34 to transfer an entity 46 of the target design 12 to the corner case state.

In the next step B4, the verification device 32 may provide the control data 40 to a test device 42. The test device 42 may then perform a predefined test procedure on the entity 46 of the target design 12 according to the control data 40, setting the entity 46 of the target design 12 to the corner case state B5. Finally, the test device 42 may store the generated sequence of steps 36 and the test case results 44 collected during the test of the entity 46 of the target design 12 according to the sequence of steps 36 by the test device 42 in a database.

In other words, in many cases, the corner case state of the target design 12 that triggers the corner case condition is known. The implementation complexity derives from defining the sequence of steps 36 that the test device 42 needs to perform on an entity 46 of the target design 12 in a test case in order to reach that corner case state. The verification device 32 may shift this complexity to multiple distributed Reinforcement Learning agents 38. Given an end-goal for the Reinforcement Learning agent 38, which is to reach the corner case state of the target design 12 that should trigger the corner case condition, the algorithm may perform multiple iterations through a state space of the target design 12 in order to reach the corner case state in an automatic way, without human intervention. The advantage of having multiple distributed Reinforcement Learning agents 38 comes from the fact that in many cases, there are multiple sequences of steps 36 to reach the corner case state of the target design 12. When the desired corner case state is reached, the sequence of steps 36 taken to reach the corner case state may be stored as the corner case scenario 28 and, together with an actual test case result 44 provided by the test device 42, passed back to the verification device 32 or a user for analysis.

### List of Reference

- 10: design specification
- 12: target design
- 14: corner case investigation module
- 16: examples of past corner cases (corner case description example database)
- 18: candidate corner case scenario
- 20: list of candidate corner case scenarios
- 22: evaluation module
- 24: evaluation value
- 26: approved corner case scenarios list
- 28: corner case scenario
- 30: sequence investigation module
- 32: verification device
- 34: set of sequences
- 36: sequence of steps
- 38: agent
- 40: control data
- 42: test device
- 44: test case result
- 46: entity
- A1-A5: steps
- B1-B5: steps

## Claims

1. A method for verification of a target design (12), the method comprising the following steps performed by a verification device (32):
- Receiving a corner case scenario (28) of the target design (12), the corner case scenario (28) comprising a corner case state of the target design (12) satisfying corner case conditions causing a corner case in the target design (12);
- Investigating by a sequence investigation module (30) of the verification device (32), a set of sequences (34) comprising one or more sequences of steps (36), each of the sequences of steps (36) comprising consecutive operation steps of the target design (12) for transferring the target design (12) from a start state of the target design (12) to the corner case state of the target design (12); and
- generating control data (40) for a test device (42) to control an entity (46) of the target design (12) to perform the operation steps of at least one sequence of steps (36) of the set of sequences (34) to transfer the an entity (46) of the target design (12) to the corner case state of the target design (12).

2. The method according to claim 1,
wherein
the sequence investigation module (30) comprises a set of reinforcement learning agents (38) configured to investigate the set of sequences (34) according to a multi-agent reinforcement learning procedure.

3. The method according to claim 1 or 2,
comprising the steps of:
- Providing by the verification device (32) the control data (40) to a test device (42),
- Controlling an entity (46) of the target design (12) by the test device (42) according to the control data (40) to transfer the entity (46) of the target design (12) to the corner case state in a predefined test procedure;
- Recording test case results (44) during the test procedure by the test device (42); and
- Providing the test case results (44) recorded during the test procedure to the verification device (32).

4. The method according to claim 3,
wherein
the entity (46) of the target design (12) is configured as a digital representation of the target design (12) provided in a test environment operated by the test device (42).

5. The method according to claim 3,
wherein
the entity (46) of the target design (12) is configured as a physical entity (46) of the target design (12) connected to the test device (42).

6. The method according to any one of the preceding claims,
comprising the following steps performed by the verification device (32):
- receiving the target design (12) and a respective target design specification (10);
- identifying by a corner case investigation module (14) of the verification device (32) candidate corner case scenarios (28) of the target design (12) in a predefined corner case identification procedure; and
- selecting the corner case scenario (28) from the candidate corner case scenarios (28).

7. The method according to claim 6,
comprising the following steps performed by the verification device (32):
- providing the candidate corner case scenarios (28) of the target design (12) to an evaluation module (22) of the verification device (32);
- evaluating respective evaluation values (24) for the respective candidate corner case scenarios (28) by the evaluation module (22);
- selecting the corner case scenario (28) from the candidate corner case scenarios (28) as a function of the evaluation values (24).

8. The method according to claim 6 or 7,
wherein
corner case investigation module (14) comprises a generative AI tasked with the identification of corner case scenarios (28) in the target design (12).

9. The method according to claim 8,
wherein
the generative AI is configured as a Large Language Model enhanced with a Retrieval Augmented Generation.

10. A method for training corner case investigation module (14) comprising the following steps performed by a verification device (32):
- receiving a target design (12) and a respective target design specification (10);
- identifying by the corner case investigation module (14) of the verification device (32) candidate corner case scenarios (28) of the target design (12) in a predefined corner case identification procedure;
- evaluating respective evaluation values (24) for the respective candidate corner case scenarios (28) by the evaluation module (22);
- selecting corner case scenarios (28) from the candidate corner case scenarios (28) as a function of the evaluation values (24); and
- providing the corner case scenarios (28) to the corner case investigation module (14).

11. A verification device (32), configured to perform a method for verification of a target design (12) according to any one of the claims 1 to 9 and/or configured to perform a method for training a corner case investigation module (14) according to claim 10.

12. A test device (42), configured to
- receive from a verification device (32) control data (40);
- control an entity (46) of a target design (12) according to the control data (40) to transfer the entity (46) of the target design (12) to a corner case state in a predefined test procedure;
- record test case results (44) during the test procedure; and
- provide the test case results (44) recorded during the test procedure to the verification device (32).

13. A computer program product comprising program code for performing a method according to any one of the preceding claims 1 to 9 and/or for performing a method according to claim 10.

14. A computer-readable storage medium comprising at least the computer program product according to claim 13.
